# EUROPÄISCHE PATENTSCHRIFT

(11) **EP 2 695 180 B1**
(45) Veröffentlichungstag und Bekanntmachung des Hinweises auf die Patenterteilung: **30.03.2016**
(21) Anmeldenummer: 12718033.9
(22) Anmeldetag: 25.01.2012
(51) Int. Cl.: H01L 21/20, C30B 29/40, C30B 25/18

(54) **VERFAHREN ZUR HERSTELLUNG EINES III/V-SI-TEMPLATS**
METHOD FOR PRODUCING A III/V SI TEMPLATE
PROCÉDÉ DE FABRICATION D'UN GABARIT DE SI III/V

(30) Priorität: 07.04.2011 DE 102011016366
(43) Veröffentlichungstag der Anmeldung: 12.02.2014
(73) Patentinhaber: NASP III/V GmbH, 35041 Marburg (DE)
(72) Erfinder: KUNERT, Bernadette, 35041 Marburg (DE)
(74) Vertreter: Richardt Patentanwälte PartG mbB
(86) Internationale Anmeldenummer: PCT/DE2012/000054
(87) Internationale Veröffentlichungsnummer: WO 2012/136176

(56) Entgegenhaltungen:
- WO-A1-89/04551
- DE-A1- 2 313 846
- US-A- 4 699 688
- SUGO M ET AL: "Growth of antiphase-domain-free GaP on Si by organometallic vapor phase epitaxy", JOURNAL OF CRYSTAL GROWTH, ELSEVIER, AMSTERDAM, NL, Bd. 88, Nr. 2, 2. April 1988 (1988-04-02), Seiten 229-235, XP024437989, ISSN: 0022-0248, DOI: 10.1016/0022-0248(88)90280-1 [gefunden am 1988-04-02]
- NEMETH I ET AL: "Heteroepitaxy of GaP on Si: Correlation of morphology, anti-phase-domain structure and MOVPE growth conditions", JOURNAL OF CRYSTAL GROWTH, ELSEVIER, AMSTERDAM, NL, Bd. 310, Nr. 7-9, 1. April 2008 (2008-04-01), Seiten 1595-1601, XP022697496, ISSN: 0022-0248, DOI: 10.1016/J.JCRYSGRO.2007.11.127 [gefunden am 2008-02-15]
- AKIRA USUI: "ATOMIC LAYER EPITAXY OF III-V COMPOUNDS: CHEMISTRY AND APPLICATIONS", PROCEEDINGS OF THE IEEE, IEEE. NEW YORK, US, vol. 80, no. 10, 1 October 1992 (1992-10-01), pages 1641-1653, XP000336388, ISSN: 0018-9219, DOI: 10.1109/5.168671

## Beschreibung

### Gebiet der Erfindung

Die Erfindung betrifft ein Verfahren zur Herstellung eines III/V-Si-Templats bzw. Rohlings vorzugsweise auf bis zu 300mm (Durchmesser) und mehr große Silizium-Substraten, mit einem solchen Verfahren hergestellte Template und Verwendungen solcher Template.

### Hintergrund der Erfindung und Stand der Technik

Die enorme Entwicklungsgeschwindigkeit der Computer- bzw. Mikrochip-Technologie ist auf die erfolgreiche Miniaturisierung der einzelnen Bauelemente eines integrierten Schaltkreises zurückzuführen. Ein integrierter Schaltkreis ist im Wesentlichen eine elektronische Verschaltung von Halbleiterbauelementen und passiven Komponenten zur Datenverarbeitung, die in einer dünnen Kristallschicht an der Oberfläche eines Silizium-Substrates hergestellt werden. Hierbei ist die Anzahl der integrierten elektronischen Bauelemente, wie z. B. Transistoren, Dioden, Widerstände und Kondensatoren, sehr hoch. Um die Leistungsfähigkeit der Mikrochips zu steigern und zeitgleich die Produktionskosten zu senken, wird die Bauelement-Packungsdichte in jeder neuen Technologiegeneration deutlich gehöht. Das wichtigste Bauelement eines integrierten Schaltkreises ist die Silizium-basierte CMOS-Logik mit n- bzw. p-MOS-FET-Transistor *(Complementary Metal-Oxid-Semiconductor).* Insbesondere die physikalischen Eigenschaften von Silizium und Siliziumdioxid haben in den letzten Jahrzehnten eine beachtliche Reduzierung der Transistorgröße erlaubt. Dementsprechend konnte die Transistordichte in der Mikrochip-Entwicklung alle 24 Monate verdoppelt werden.

Transistoren sind grundsätzlich Widerstände, die durch eine äußere Gate-Spannung (Spannung an der Steuerelektrode) beeinflusst werden. Entscheidende Leistungsmerkmale dieser Bauelemente sind hohe Schaltfrequenzen und eine geringe Wärmedissipation im Betrieb. Bisher konnten diese Leistungsmerkmale durch die Strukturreduktion der Transistoren verbesser werden. Jedoch sind die einzelnen Bauelement-Dimensionen mittlerweile so gering, dass grundlegende physikalische Grenzen auftreten und eine weitere Miniaturisierung zu keiner Verbesserung führt. An dieser Stelle werden neben Silizium und Siliziumdioxid inzwischen neue Materialien bei der Herstellung von integrierten Schaltkreisen eingesetzt, deren physikalischen Eigenschaften zu einer Verbesserung der Bauelement-Funktionsweise führen.

Insbesondere wird auch der Einsatz von III/V-Halbleitermaterialien in der CMOS Technologie diskutiert. Die Klasse der III/V-Halbleiterkristalle setzt sich zu je 50% aus den chemischen Elementen der Gruppe-III und der Gruppe-V zusammen. Die Bindungseigenschaften der jeweiligen chemischen Elemente bestimmen hierbei die elektronischen und optischen Eigenschaften der III/V-Halbleiterverbindung. Da die Kompositionsmöglichkeiten innerhalb der Klasse der III/V-Halbleitermaterialien sehr groß ist, können entsprechend sehr unterschiedliche Halbleitbauelemente realisiert werden. Die Integration von III/V-Halbleiterschichten auf Si-basierte integrierte Schaltkreise ermöglicht nun einerseits bestehende Funktionalitäten zu verbessern, wie z.B. die Anwendung von III/V-Kanalschichten für Transistoren. Andererseits können neuartige Device-Konzepte realisiert werden, wie z. B. die Integration von III/V-Laserdioden für die optische Datenverarbeitung auf Mikrochip-Ebene.

Ein weiterer entscheidender Punkt für die Anwendung von neuen Materialien zur Leistungssteigerung der integrierten Schaltkreise ist das Integrationsverfahren. Hierbei gilt es, trotz neuer Materialien und/oder Device-Konzepte, die Produktionskosten niedrig zu halten. Im Gegensatz zu hybriden Integrationsansätzen (siehe beispielsweise EP 0297483 stellt das monolithische Wachstum von III/V Halbleiterschichten auf Si-Substrate ein sehr kostengünstiges Verfahren dar. Hierbei wird der III/V Halbleitermischkristall direkt mit dem Silizium-Trägersubstrat verbunden (siehe lediglich beispielsweise US 5,937,274 oder PCT/DE 2006/000140).

Aufgrund der unterschiedlichen Materialklasse von Silizium und III/V-Halbleitern müssen bei der monolithischen Verbindung folgende Aspekte berücksichtig werden: Die atomaren Bindungseigenschaften von Silizium und den Elementen der III/V-Klasse sind sehr unterschiedlich, folglich weisen die meisten III/V-Kristalle eine andere Gitterkonstante als Silizium auf. Der Unterschied in der Gitterkonstante führt wiederum zur Ausbildung von Fehlversetzungsdefekte während der Abscheidung eines III/V-Films auf Si. Außerdem kann eine Interdiffusion an der Grenzfläche zwischen Silizium und dem III/V-Kristall und/oder Verschleppungseffekte während des Kristallwachstums zu einer schwer kontrollierbaren Dotierung im jeweiligen Wirtskristall führen.

Ein weiteres Problem geht auf die unterschiedliche Kristallbasis von Si und III/V-Kristalle zurück: Sofern die Si-Oberfläche nicht atomar-doppelgestufte Si-Terrassen aufweist, bilden sich Anti-Phasen-Defekte im III/V-Film. Seit den 80iger Jahren wurde an der monolithischen Integration von III/V-Schichten auf Silizium geforscht. Grundsätzlich sind die oben genannten Herausforderungen bei der III/V-Abscheidung auf kleine Si-Substrate von bis zu 2inch Durchmesser gelöst, nur die Ausbildung von Fehlversetzungen bei der Integration von III/V Materialien mit unterschiedlicher Gitterkonstante zu Silizium erschwert immer noch die Realisierung von hocheffizienten Bauelementen mit hinreichender Lebendauer.

Aufgrund der unterschiedlichen Kristallbasis von Silizium und III/V-Mischkristallen können sich bei der monolithischen Abscheidung sehr schnell Anti-Phasen-Defekte in der III/V-Schicht bilden. Diese Defekte beeinträchtigen wiederum die Betriebseigenschaften der Bauelemente. Die Ausbildung von Anti-Phasen-Defekte kann durch die gezielte Präparation der Silizium-Oberfläche verhindert werden.

Eine Anti-Phasen-frei III/V-Integration ist dann möglich, wenn durch eine spezielle Substratvorbehandlung Doppelstufen aus jeweils zwei Si-Atomlagen erzeugt werden. Diese Oberflächenpräparation ist jedoch vorzugsweise auf leicht fehlorientierten [(001) 2° bis 6°off in <110> Richtung] Substraten möglich. In der Literaturstelle B. Kunert, I. Németh, S. Reinhard, K. Volz, W. Stolz, Thin Film Solid 17 (2008) 140 wurde erstmals auch die defektfreie Abscheidung von GaP auf exakt-orientierten Substraten gezeigt, jedoch unterliegt die Substratspezifikation immer noch einer zusätzlichen Auflage: (001) (kleiner) < 0.15° off in <110> Richtung.

Da die heutige Si-basierte CMOS Technologie sehr komplex und weit entwickelt ist, muss die Integration von neuen Materialien sehr genau auf das CMOS Produktionsverfahren abgestimmt werden. Jeglicher größerer Eingriff oder Änderungsanspruch an den derzeitigen CMOS Prozess würde die Entwicklungskosten deutlich erhöhen. Die CMOS Standard-Si-Substratspezifikation bzgl. der Orientierung ist (001) +/-0.5 off in beliebiger Richtung. Die Umstellung der CMOS Technologie auf fehlorientierte [(001) 2° bis 6°off in <110> Richtung] Substrate wäre jedoch aufgrund der erneuten Prozessanpassung viel zu kostspielig und unwirtschaftlich.

Die obengenannte Substratspezifikation von (001) <0.15° off in <110> Richtung würde jedoch in die Spezifikation des CMOS Prozesses fallen. Allerdings ist das gezielte Wafer-Sägen entsprechend dieser geringen Fehlorientierung sehr kompliziert und aufwendig und stellt immer noch eine große technologische Herausforderung dar. Die Si-Substratgröße in der aktuellen CMOS Technologie liegt mittlerweile bei einem Durchmesser von 300mm (einzelne Fabriken arbeiten auch noch mit kleineren Wafer). Die Massenproduktion von 300mm Si- Wafer mit einer Fehlorientierung von <0.15° in <110> Richtung würde jedoch die Fertigungskosten drastisch steigern und damit wäre die Anwendung dieser Substrate wirtschaftlich fragwürdig. Somit stellt insbesondere die Anti-Phasen-frei III/V-Integration auf 300 mm Si Substrate für den CMOS Prozess ein ungelöstes technologisches und wirtschaftliches Problem da.

Eine weitere technologische Herausforderung geht auf den unterschiedlichen thermischen Ausdehnungskoeffizient von Silizium und den Verbindungen der III/V-Halbleiterkristalle zurück. Wird die unterschiedliche Abhängigkeit der Gitterkonstanten von der Temperatur nicht im Integrationsprozess systematisch berücksichtigt, können sich Fehlversetzungen oder Risse in der III/V Schicht bilden. Bei großen Substratdurchmessern kann sogar der Si- Wafer in Mitleidenschaft gezogen werden (Wafer-Flipping) und Relaxationsdefekte ausbilden.

Die Literaturstelle M. Sugo, A Yamamoto, M. Yamaguchi, Journal of Crystal Growth 88 (1988) 229-235 offenbart eine Forschung des epitaxialen Wachstums von GaP auf Si (100) Substraten mittels einer metallorganischen Gasphasenepitaxie, wobei der Einfluss der Substratvorbehandlung auf das Wachstum von Antiphasen-Domänen-frei GaP untersucht wurde.

Die Literaturstelle I. Nemeth, B. Kunert, W. Stolz, K. Volz, Journal of Crystal Growth 310 (2008) 1595-1601 offenbart ein Verfahren zum Wachsen von epitaxiallen GaP Schichten auf (001) Si Substraten sowohl mittels der Gasphasenepitaxie als der metallorganischen Gasphasenepitaxie. Das Verfahren umfasst des Folgendes: Entfernen einer Oxid-Schicht von einer Oberfläche eines Substrats; Aufwachsen einer Si Pufferschicht bei einer Temperatur von 850°C, die eine Dicke von 500 nm aufweist, Ausheilen der Si Pufferschicht bei einer Temperatur von 975°C über eine Dauer von 10 min, um Erzeugung von atomardoppelgestuften Si -Terrassen auszulösen; Aufwachsen einer dünnen GaP Schicht bei einer Temperatur von 400-500°C, die eine Dicke von 3-5 nm aufweist; Aufwachsen einer dicken GaP Schicht bei einer Temperatur von 450-675°C, die eine Dicke von 40-140 nm aufweist.
Die US 4699688 offenbart ein doppelstufiges Verfahren zum Wachsen von GaAs Schichten, wobei eine dünne Keimschicht bei einer Temperatur von ca. 450°C vor einem Aufwachsen einer dicken Pufferschicht bei einer Temperatur von ca. 600°C aufgewachsen wird.
Die Literaturstelle A. Usui, Proceedings oft he IEEE 80(1992)October, No.10, 1641-1653 offenbart eine atomare Schichtabscheidung (atomic layer deposition, ALD) für ein Wachstum von III-V Verbindungen.

Die Offenlegungsschrift DE2313846 offenbart ein Verfahren zur Herstellung einer heteroepitaktisch abgeschiedenen einkristallinen Schicht eines Verbindungs-Halbeleiters auf einem Substratkörker aus Silizium, dadurch gekennzeichnet, das zur Reduzierung und Entfernung einer SiO₂-Schicht des Substrartkörpers dieser in einer Atomsphäre aus gereinigtem Wasserstoff auf Temperaturen zwischen 950° und 1100° erhitzt wird, dass der Substratkörper dann zusätzlich mit einer ChlorWasserstoff-Atmosphäre in Bereinigung gebracht und die Temperatur des Körpers auf eine Temperatur Halbleitermaterial verringert wird, dass man aus dem inzwischen gasförmig zugeführten Halbleitermaterial und/oder aus den inzwischen gasförmig zugeführten Komponenten der Materials die Schicht aus dem Halbleitermaterial auf dem Substratkörper epitaktisch aufwachsen lässt, wobei der Körper während des Übergangs seiner Temperatur auf den niedrigeren Wert im wesentlichen auf oder über der Temperatur der ihn umgehenden Atmosphäre gehalten wird.

### Technisches Problem der Erfindung

Der Erfindung liegt daher das technische Problem zu Grunde, ein Verfahren zur Herstellung eines monolithischen III/V-Si-Templates anzugeben, mit minimalen Versetzungsdefekten und mit minimalen Anti -Phasen-Defekten.

### Grundzüge der Erfindung

Zur Lösung dieses technischen Problems lehrt die Erfindung ein Verfahren zur Herstellung eines monolithischen Templates enthaltend einen Si Wafer mit einer auf eine Oberfläche des Si Wafers epitaktisch aufgebrachten Schicht eines III/V Halbleiters, wobei der III/V Halbleiter eine Gitterkonstante aufweist, welche weniger als 10% von jener des Si abweicht, mit den folgenden Verfahrensstufen: A) optional wird die Oberfläche des Si Wafers deoxidiert, B) wird auf die Oberfläche des deoxidierten Si Wafers eine Si Schicht bei einer Wafertemperatur von 600-1200°C, einer Wachstumsrate von 0,01-20 µm/h und einer Schichtdicke von bis zu 5 µm auf die Oberfläche des Si Wafers epitaktisch aufgewachsen, C) wird die Oberfläche der Si Schicht einer Ätzverfahrensstufe mittels eines aktiven Cl-haltigen Gases, bei einer Wafertemperatur von 600-1200°C über eine Dauer von bis zu 60 min über die Oberfläche bei einer Ätzrate von bis zu 5 µm/h, unterworfen, D) auf die Oberfläche der Si Schicht wird bei einer Wafertemperatur von 350-650 °C, einer Wachstumsrate von 0,1-2 µm/h und einer Schichtdicke von 1-100 nm eine Schicht aus dem III/V Halbleiter epitaktisch aufgewachsen, E) auf die in Stufe D) erhaltene Schicht wird bei einer Wafertemperatur von 500-800 °C, einer Wachstumsrate von 0,1-10 µm/h und einer Schichtdicke von 10-150 nm eine Schicht aus einem III/V-Halbleiter, gleich mit oder verschieden von dem in Stufe D) aufgebrachten III/V Halbleiter, epitaktisch aufgewachsen. Die Erfindung umfasst also ein spezielles Verfahren der kristallinen Abscheidung von Gruppe- IV Materialien als auch III/V-Halbleiterverbindungen auf Si-Substraten, wobei diese Si-Substrate mit einem Durchmesser von 200mm, 300mm und mehr ausgestattet und optional mittels Maskierung strukturiert sein können. Die Kristallabscheidung bzw. das Kristallwachstum findet typischerweise mittels der Gasphasen-Epitaxie statt. Mit dem Verfahren wird die Integration einer dünnen Fehlversetzungs- freien III/V-Halbleiterschicht auf Si-Substrat angestrebt und idealerweise auch erreicht.

Zu Beginn des Verfahrens können die Si-Substrate in einem ersten Prozessschritt ausgeheizt werden, um das Siliziumdioxid von der Oberfläche zu entfernen. Im nächsten Schritt kann bei Bedarf ein Siliziumpuffer abgeschieden werden. Abhängig vom Integrationskonzept kann dieser Siliziumpuffer dotiert werden. Die Si-Substratoberflache mit oder ohne zusätzliche Pufferschicht wird beispielsweise, aber nicht zwingend abhängig von der Kristall-Fehlorientierung (off- oder exakt-orientiert) speziell präpariert. Die Abscheidung der Stufen D) und E) erfolgt in zwei Prozessschritte: Zuerst wird ein dünner III/V-Film bei niedrigen Temperaturen aufgewachsen (Stufe D)) und dann die Reaktortemperatur für die weitere Kristallabscheidung deutlich erhöht (Stufe E)). Die Zusammensetzung der III/V-Schicht wird je nach Schichtdicke und Wachstumstemperatur angepasst, um die Ausbildung von Fehlversetzungen und Risse zu vermeiden bzw. weitestgehend zu reduzieren.

Im Gegensatz zu den meisten anderen III/V-Mischkristallen ist die monolithische Integration von dünnen GaP Schichten auf Si Substrat ohne die Ausbildung von Versetzungsdefekte möglich, da beide Kristalle eine ähnliche Gitterkonstante besitzen. Damit ist die Anwendung von GaP als erste III/V-Nukleationsschicht technologisch sehr wichtig, da es auch die weitere Integration von Materialien mit unterschiedlicher Gitterkonstante deutlich vereinfacht. Dieses GaP/Si-Template kann folglich für sehr unterschiedliche III/V-Materialien und (elektronische) Bauelement-Konzepte auf Si-Mikroelektronik verwendet werden. Derzeit arbeiten verschiedene Firmen, Institute und Universitäten an konkreten Integrationskonzepten unter der Anwendung eines GaP/Si-Templates.

Die Erfindung ermöglicht erstmals die Abscheidung von praktisch Fehlversetzungs-freien III/V-Halbleitermaterialien auf exaktem und fehlorientiertem Silizium-Substrat mit einem Durchmesser von bis zu 300 mm. Bei der Prozessentwicklung wurde ebenfalls berücksichtigt, dass vor der Abscheidung von III/V-Materialien ein Siliziumpuffer mit beliebiger Dotierung realisiert werden kann. Dieser Schritt ist besonders hilfreich, um einerseits die Substratoberfläche zu optimieren, selektives Silizium-Überwachsen insbesondere bei einer Maskenstrukturierung zu ermöglichen und um angepasste Si-Kontaktschichten für die Standard CMOS Metallisierung abzuscheiden. Die Verwendung von 300 mm Wafern entspricht der heutigen Si-basierten CMOS Technologie, damit ermöglicht das Integrationsverfahren auf entsprechenden Wafern eine bestmögliche Kompatibilität zum derzeitigen Entwicklungsstand der CMOS Technologie.

Außerdem ist durch die Verwendung von 300 mm Substraten eine ideale Wirtschaftlichkeit der Produktionskosten gewährleistet. Insbesondere weil der Prozess in einer Epitaxie-Anlage realisiert worden ist, die mit einem automatischen Scheiben-"Handler" verbunden ist und damit ein automatischer Substrattransfer möglich ist.

Neben dem Einsatz der Erfindung in der Si-Mikrotechnologie ist die Abscheidung von III/V-Materialien auf großflächigen Si-Substraten auch in anderen Anwendungsbereichen sehr vorteilhaft. Hierbei möchte man ausnutzen, dass Si-Substrate im Vergleich zu herkömmlichen III/V-Substraten deutlich günstiger sind und auch größere Substratscheiben hergestellt werden können.

Durch die Integration von herkömmlichen III/V-basierten Bauelementen wie z.B. LEDs, Detektoren oder Solarzellen auf Si-Substrate könnten die Produktionskosten signifikant reduziert werden. An dieser Stelle wäre auch der Einsatz von fehl-orientierten ((001) 2° bis 6°off in <110> Richtung) Si-Substraten möglich.

Im Einzelnen sind folgend bevorzugte Varianten des erfindungsgemäßen Verfahrens beschrieben.

Die zu beschichtende Oberfläche des Si Wafers ist vorzugsweise eine (001) Si Oberfläche, mit 0-6°, insbesondere 0-2°, Fehlorientierung in Richtung <110>. Zusätzlich darf der Si Wafer eine Maskenstruktur aufweisen. Bei einer Fehlorientierung von ≤ 1° darf die Richtung der Fehlorientierung von <110> abweichen.

Die Stufe A) kann durch Ausheizen auf eine Wafertemperatur von 800-1200 °C, insbesondere 900-1100 °C, beispielsweise 950-1050 °C, für eine Dauer von 1 s bis 30 min, insbesondere eine Dauer von 1-30 min, beispielsweise 5 bis 15 min, in einer Inertgasatmosphäre durchgeführt werden. Die Inertgasatmosphäre kann Stickstoff oder Wasserstoff sein. Der (Gesamt-) Gasdruck kann im Bereich 50-1000 mbar, vorzugsweise 100-300 mbar, liegen. Der Gesamtgasfluss kann im Bereich 6-200 l/min, insbesondere 6-50 l/min, beispielsweise 40-50 l/min, liegen.

In der Stufe B) wird die Si Schicht bei einer Wafertemperatur von 600-1200 °C, insbesondere von 725-1100 °C, beispielsweise von 850-1050 °C, einer Wachstumsrate von 0,01-20 *µ*m/h, insbesondere 1-10 *µ*m/h, beispielsweise 3-10 *µ*m/h, und einer Schichtdicke von bis zu 5 *µ*m, insbesondere 0,1-2 *µ*m, beispielsweise 0,5-1,5 *µ*m, aufgewachsen werden. Die Inertgasatmosphäre kann Stickstoff oder Wasserstoff sein unter zusätzlichem Einsatz eines gasförmigen Si-Edukts. Optional erfolgt eine Dotierung mit B, Ga, P, Sb und/oder As in einer p- oder n-Dotierungskonzentration von 10¹⁵-10²¹ cm⁻³, beispielsweise 10¹⁷-10²¹ cm⁻³. Der (Gesamt-) Gasdruck kann im Bereich 50-1000 mbar, vorzugsweise 100-300 mbar, liegen. Der Gesamtgasfluss kann im Bereich 6-200 l/min, insbesondere 6-50 l/min, beispielsweise 40-50 l/min, liegen.

In der Stufe C) wird ein aktives Cl-haltiges Gas bei einer Wafertemperatur von 600-1200 °C, insbesondere 725-1100 °C, beispielsweise 850-1050 °C, über eine Dauer von bis zu 60 min, insbesondere bis zu 15 min, beispielsweise 1 bis 10 min, über die Oberfläche bei einer Ätzrate von bis zu 5 *µ*m/h, vorzugsweise bis zu 2 *µ*m/h, geleitet werden. Als aktives Gas kommt beispielsweise HCl in Frage (Rest: beispielsweise Stickstoff). Der (Gesamt-) Gasdruck kann im Bereich 50-1000 mbar, vorzugsweise 600-900 mbar, liegen. Der Gesamtgasfluss kann im Bereich 6-200 l/min, insbesondere 6-50 l/min, beispielsweise 10-15 l/min, liegen.

In Stufe D) kann ein GaₓB_{y}Al_{z}P oder eine GaN_{w}Pᵥ Halbleiter aufgewachsen werden, wobei x=0-1, y=0-0,1 und z=0-1, oder w=0-0,1 und v=1-w, insbesondere x=1, y=0 und z=0, wobei die Summe aus x, y und z für GaₓB_{y}Al_{z}P stets 1 ergibt. Die Wafertemperatur kann vorzugsweise im Bereich 400-625 °C, insbesondere 420-500 °C, liegen. Die III/V Wachstumsrate kann im Bereich 0,1-2 *µ*m/h, insbesondere 0,5-1,5 Monolayer/s, beispielsweise 1 Monolayer/s, liegen. Der Wachstumsmodus kann kontinuierlich sein vorzugsweise mittels Fluss-Modulations-Epitaxie (Flow rate modulation epitaxy (FME)) sowie mittels atomare Schichtabscheidung (atomic layer deposition (ALD)), was auch für die anderweitig allgemein und speziell geschriebenen Schichten angewandt werden kann. Die Schichtdicke liegt vorzugsweise im Bereich 2-50 nm, insbesondere 2-8 nm. Das Gasverhältnis V/III kann im Bereich 5-200, insbesondere 10-150, beispielsweise 50-70, liegen. Der (Gesamt-) Gasdruck kann im Bereich 50-1000 mbar, vorzugsweise 50-500 mbar, insbesondere 50-150 mbar, liegen. Der Gesamtgasfluss kann im Bereich 6-200 l/min, insbesondere 6-60 l/min, beispielsweise 40-60 l/min, liegen. Optional erfolgt eine Dotierung mit Zn, Te, S, C, Mg und/oder Si in einer p- oder n-Dotierungskonzentration von 10¹⁵-10²¹ cm⁻³, beispielsweise 10¹⁷-10²¹ cm⁻³. Es kann aber auch ohne Dotierung gearbeitet werden.

In Stufe E) kann ein GaₓB_{y}Al_{z}P oder eine GaN_{w}Pᵥ Halbleiter aufgewachsen werden, wobei x=0-1, y=0-0,1 und z=0-1, oder w=0-0,1 und v=1-w, insbesondere x=0-1, y=0-0,06 und z=0-1, wobei die Summe aus x, y und z für GaₓB_{y}Al_{z}P stets 1 ergibt. Die Wafertemperatur kann vorzugsweise im Bereich 525-725 °C, insbesondere 650-700 °C, liegen. Die III/V Wachstumsrate kann im Bereich 0,1-10 *µ*m/h, insbesondere 0,5-5 *µ*m/h, beispielsweise 2-2,5 *µ*m/h, liegen. Die Schichtdicke liegt vorzugsweise im Bereich 30-100 nm, insbesondere 40-70 nm. Das Gasverhältnis V/III kann im Bereich 5-200, insbesondere 10-100, beispielsweise 10-30, liegen. Der (Gesamt-) Gasdruck kann im Bereich 50-1000 mbar, vorzugsweise 50-900 mbar, insbesondere 50-150 mbar, liegen. Der Gesamtgasfluss kann im Bereich 6-200 l/min, insbesondere 6-60 l/min, beispielsweise 40-60 l/min, liegen. Optional erfolgt eine Dotierung mit Zn, Te, S, C, Mg und/oder Si in einer p- oder n-Dotierungskonzentration von 10¹⁵-10²¹ cm⁻³, beispielsweise 10¹⁷-10²¹ cm⁻³. Es kann aber auch ohne Dotierung gearbeitet werden.

Ein Beispiel, das nicht Teil der Erfindung ist, betrifft des Weiteren ein monolithisches Templat, erhältlich mittels eines erfindungsgemäßen Verfahrens. Es betrifft auch die Verwendung eines solchen Templates zur monolithischen Integration von III/V Halbleiterschichten basierten Bauelementen wie Transistoren, Laserdioden, LEDs, Detektoren sowie Solarzellen auf einem Si Substrat, insbesondere auf einem Si Substrat mit einem Durchmesser von mehr als 6 cm, vorzugsweise mehr als 10 cm, insbesondere mehr als 20 cm. Dabei können anschließend an die Stufe E) weitere III/V Halbleiterschichten epitaktisch aufgewachsen und III/V Halbleiter enthaltende elektronische Bauelemente ausgebildet werden.

Im Folgenden wird die Erfindung mittels lediglich Ausführungsformen darstellenden und nicht beschränkenden Beispielen näher erläutert.

### Beispiel 1: eingesetzte Apparaturen

Die Kristallabscheidung findet mittels der Gasphasen-Epitaxie statt. Hierfür wird eine Epitaxie-Anlage benötigt, die das Kristallwachstum auf 300 mm (Durchmesser) große Si-Substrate ermöglicht. Außerdem kann im Verfahren die Temperaturverteilung des Suszeptor radial variiert werden können, um das Temperaturprofil des Si-Wafers genau einstellen zu können. Bevorzugt wird hierbei die CCS(Close-Couple-Showerhead)-Crius Anlage der Firma Aixtron verwendet.

Alle beschriebenen Prozessschritte können in einem einzigen Epitaxie-Reaktor durchgeführt werden. Um Verschleppungseffekte zu minimieren oder um das Integrationsverfahren an weitere Prozessschritte anzupassen, können auch zwei Epitaxie-Reaktoren verwendet werden. Hierbei bietet sich ein optionaler SubstratTransfer nach dem Prozessschritt C) und/oder D) an.

### Beispiel 2: eingesetzte Substanzen bzw. Gase

Folgende Edukte bzw. Precursoren können in dem Prozess eingesetzt werden:
Edukte für Silizium: Silan, Dichlorsilan, Disilan, Trisilan, Neopentasilan, Tetrachlorosilan (SiCl4), Ditertiarybutylsilan (DitButSi)
Edukte für Gallium: Triethylgallium (TEGa), Trimethylgallium (TMGa), Tritertiarybutylgallium Edukte für Bor: Triethylboran (TEB), Tritertiarybutylboran, Diboran, Boran-Amin-Addukte wie z.B. Dimethylaminoboran
Edukte für Aluminium: Trimethylalluminium (TMAl), Tritertiarybutyaluminium, Aminaddukte wie z.B. Dimethyaminoaluminium
Edukte für Phosphor: Tertiarybutylphoshin (TBP), Phosphin
Edukte für Arsen: Tertiarybutylarsin (TBAs), Arsin, Trimethylarsin (TMAs)
Edukte für Antimon: Triethylantimon (TESb), Trimethylantimon (TMSb)
Edukte für die Dotierung der III/V-Schicht: Diethyltellurium (DETe), Dimethylzink (DMZn), Diethylzink (DEZn), DitButSi, Silan, Ditertiarybutylsulphid, Bis-Cyclopentadienyl-Magnesium, Tetrabrommethan
Cl-haltige Edukte: HCl, Dichlorsilan, SiCl4

Als Trägergas wird Stickstoff oder Wasserstoff verwendet.

Bevorzugt werden folgende Edukte eingesetzt: Silan, Disilan, Dichlorsilan, HCl, TEGa, TEB, TMAl und TBP. Das bevorzugte Trägergas ist Wasserstoff.

### Beispiel 3: GaP auf (001) exakt Silizium

Als Ausführungsbeispiel wird die Abscheidung einer dünnen GaP Schicht auf 300 mm Silizium-Substrat beschrieben. In diesem Ausführungsbeispiel ist das Si-Substrat p-dotiert und exakt orientiert. Die GaP-Schichtdicke ist 50 nm dick und n-dotiert im Bereich 3*10¹⁸ cm⁻³. Folgende Edukte werden eingesetzt: Silan, TEGa, TBP und DETe.

Der Si-Wafer wird mittels eines automatischen Scheiben-Transfer-System der Firma Brooks in einem CCS-Crius-Reaktor der Firma Aixtron transferiert. Als Trägergas wird gereinigter Wasserstoff verwendet, während Silan, TEGa, TBP und DETe als Edukte für Si, Ga, P und Te zur Verfügung stehen.

Im ersten Schritt wird das native Siliziumdioxid in einem 10 minütigen Ausheizschritt von der Substratoberfläche entfernt (Stufe A). Der Reaktordruck ist 200 mbar, der Gesamtgasfluss 48 l/min und die Wafertemperatur 1000 °C.

Für die Abscheidung eines 1*µ*m dicken Si Puffers (Stufe B)) werden folgende Wachstumsparameter eingestellt: Reaktordruck 200 mbar, Gesamtgasfluss 48 l/min, Wafertemperatur 900 °C. Unter diesen Bedingungen führt ein Silan-Fluss von 8.9E-4 Mol/min zu einer Wachstumsrate von 4 *µ*m/h.

Nach dem Pufferwachstum wird die Silizium-Oberfläche präpariert (Stufe C)). Hierfür wird ein HCl-Fluss von 5.4E-3 Mol/min für 5 min in den Reaktor gegeben. Diese Oberflächenbehandlung injiziert die Ausbildung von doppelgestuften Si-Terrassen, um die Ausbildung von Anti-Phasen-Defekte zu minimieren. Der Reaktordruck ist 700 mbar und der Gesamtfluss ist 12 l/min.

Die folgende Nukleation der GaP-Schicht bedingt erneut die Anpassung der Wachstumsbedingungen: Die Wafertemperatur wird in Stufe D) auf 450°C erniedrigt und ein Reaktordruck von 100 mbar und ein Gesamtgasfluss von 48 l/min eingestellt. Die Mol-Flüsse der III/V-Edukte sind 2.52E-4 Mol/min für TEGa und 1.51E-2 Mol/min für TBP.

Im ersten Schritt der III/V-Nukleation wird TBP für 10 s in den Reaktor gegeben (TBP-Vorlauf). Danach folgt das GaP-Wachstum per FME *(Flow rate Modulation Epitaxy).* Dies bedeutet im Einzelnen, dass nach dem TBP-Vorlauf folgende Edukt-Schalt-Sequenz für den Reaktor mehrmals wiederholt wird: 1 s Wachstumsunterbrechung ohne Edukte -> 1 s TEGa -> 1 s Wachstumsunterbrechung ohne Edukte -> 1 s TBP. Diese Schalt-Schleife wird 22-mal wiederholt und dadurch 6 nm GaP abgeschieden. Der TEGa-Mol-Fluss ist so eingestellt, dass in einer Sekunde die Waferoberfläche mit einer Monolage Ga belegt wird.

Im nächsten Schritt (Stufe E)) wird unter einer TBP-Stabilisierung die Wafertemperatur auf 675 °C erhöht.

Außerdem werden neue Mol-Flüsse für die Edukte eingestellt: 5.81E-4 Mol/min für TEGa und 1.16E-2 Mol/min für TBP. Dadurch erniedrigt sich das V/III-Verhältnis von 60 auf 20. Das Gasphasenverhältnis DETe/TEGa wird so eingestellt, dass bei 675 °C eine n-Dotierung von 3*10¹⁸ cm⁻³ erreicht wird. Mit einer Wachstumsrate von 2.3 *µ*m/s wird eine GaP Schicht von 44 nm abgeschieden. Dieses GaP/Si-Template wird abschließend unter TBP Stabilisierung abgekühlt.
Diese Verfahrensparameter sind auch auf (001) Si Wafer mit meiner Fehlorientierung von bis zu 2° off in <110> Richtung anwendbar.

### Beispiel 4: GaP auf (001) Silizium, 2° off in <110> Richtung des Si Wafers

Als Beispiel, das nicht Teil der beanspruchten Erfindung ist, wird die Abscheidung einer dünnen GaP Schicht auf 300 mm Silizium-Substrat beschrieben. In diesem Ausführungsbeispiel ist das Si-Substrat p-dotiert und hat eine Fehlorientierung von 2° off in <110> Richtung. Die GaP-Schichtdicke ist 50 nm. Folgende Edukte werden eingesetzt: Silan, TEGa und TBP.
Der Si-Wafer wird mittels eines automatischen Scheiben-Transfer-System der Firma Brooks in einem CCS-Crius-Reaktor der Firma Aixtron transferiert. Als Trägergas wird gereinigter Wasserstoff verwendet, während Silan, TEGa und TBP als Edukte für Si, Ga und P zur Verfügung stehen.

Im ersten Schritt wird das native Siliziumdioxid in einem 10 minütigen Ausheizschritt von der Substratoberfläche entfernt (Stufe A)). Der Reaktordruck ist 200 mbar, der Gesamtgasfluss 48 l/min und die Wafertemperatur 1050 °C.

Für die Abscheidung eines 1*µ*m dicken Si Puffers (Stufe B)) werden folgende Wachstumsparameter eingestellt: Reaktordruck 200 mbar, Gesamtgasfluss 48 l/min, Wafertemperatur 1050 °C. Unter diesen Bedingungen führt ein Silan-Fluss von 8.9E-4 Mol/min zu einer Wachstumsrate von 8,3 *µ*m/h.

Eine Stufe C) wird in diesem Beispiel nicht ausgeführt, es schließt sich unmittelbar die Stufe D) an.

Die folgende Nukleation der GaP-Schicht bedingt erneut die Anpassung der Wachstumsbedingungen: Die Wafertemperatur wird in Stufe D) auf 450 °C erniedrigt und ein Reaktordruck von 100 mbar und ein Gesamtgasfluss von 48 l/min eingestellt. Die Mol-Flüsse der III/V-Edukte sind 2.52E-4 Mol/min für TEGa und 1.51E-2 Mol/min für TBP.
Im ersten Schritt der III/V-Nukleation wird TBP für 10 s in den Reaktor gegeben (TBP-Vorlauf). Danach folgt das GaP-Wachstum per FME *(Flow rate Modulation Epitaxy).* Dies bedeutet im Einzelnen, dass nach dem TBP-Vorlauf folgende Edukt-Schalt-Sequenz für den Reaktor mehrmals wiederholt wird: 1 s Wachstumsunterbrechung ohne Edukte -> 1 s TEGa -> 1 s Wachstumsunterbrechung ohne Edukte -> 1 s TBP. Diese Schalt-Schleife wird 22-mal wiederholt und dadurch 6 nm GaP abgeschieden. Der TEGa-Mol-Fluss ist so eingestellt, dass in einer Sekunde die Waferoberfläche mit einer Monolage Ga belegt wird.

Im nächsten Schritt (Stufe E)) wird unter einer TBP-Stabilisierung die Wafertemperatur auf 675 °C erhöht. Außerdem werden neue Mol-Flüsse für die Edukte eingestellt: 5.81E-4 Mol/min für TEGa und 1.16E-2 Mol/min für TBP. Dadurch erniedrigt sich das V/III-Verhältnis von 60 auf 20. Mit einer Wachstumsrate von 2.3 *µ*m/s wird eine GaP Schicht von 44 nm abgeschieden. Dieses GaP/Si-Template wird abschließend unter TBP Stabilisierung abgekühlt.

Diese Verfahrensparameter sind auch auf (001) Si Wafer mit meiner Fehlorientierung von bis zu 6° off in <110> Richtung anwendbar.

## Patentansprüche

1. Verfahren zur Herstellung eines monolithischen Templates enthaltend einen Si Wafer mit einer auf eine Oberfläche des Si Wafers epitaktisch aufgebrachten Schicht eines III/V Halbleiters, wobei der III/V Halbleiter eine Gitterkonstante aufweist, welche weniger als 10% von jener des Si abweicht, mit den folgenden Verfahrensstufen:
B) eine Si Schicht wird bei einer Wafertemperatur von 600-1200°C, einer Wachstumsrate von 0,01-20 µm/h und einer Schichtdicke von bis zu 5 µm auf die Oberfläche des Si Wafers epitaktisch aufgewachsen wird,
C) eine Oberfläche der Si Schicht wird einer Ätzverfahrensstufe mittels eines aktiven Cl-haltigen Gases, bei einer Wafertemperatur von 600-1200°C über eine Dauer von bis zu 60 min über die Oberfläche bei einer Ätzrate von bis zu 5 µm/h, unterworfen,
D) auf die Oberfläche der Si Schicht wird bei einer Wafertemperatur von 350-650°C, einer Wachstumsrate von 0,1-2 µm/h und einer Schichtdicke von 1-100 nm die Schicht aus dem III/V Halbleiter epitaktisch aufgewachsen,
E) auf die in Stufe D) erhaltene Schicht wird bei einer Wafertemperatur von 500-800°C, einer Wachstumsrate von 0,1-10 µm/h und einer Schichtdicke von 10-150 nm eine Schicht aus einem III/V-Halbleiter, gleich mit oder verschieden von dem in Stufe D) aufgebrachten III/V Halbleiter, epitaktisch aufgewachsen.

2. Verfahren nach Anspruch 1, wobei vor der Stufe C) in einer Stufe A) die Oberfläche des Si Wafers durch Ausheizen auf eine Wafertemperatur von 800-1200°C für eine Dauer von 1 s bis 30 min in einer Inertgasatmosphäre deoxidiert wird.

3. Verfahren nach einem der Ansprüche 1 oder 2, wobei in der Stufe D) die Schicht epitaktisch mittels atomarer Schichtabscheidung (atomic layer deposition (ALD)) aufgewachsen wird.

4. Verfahren nach Anspruch 1, wobei die Oberfläche des Si Wafers eine (001) Si Oberfläche, mit 0-6° Fehlorientierung in Richtung <110>, ist, wobei bei einer Fehlorientierung von ≤ 1° die Richtung der Fehlorientierung von <110> abweichen kann.

5. Verfahren nach einem der Ansprüche 1 bis 4, wobei in der Stufe D) der III/V Halbeiter ein GaₓB_{y}Al_{z}P Halbleiter ist, wobei x = 0-1, y = 0-0,1 und z = 0-1, wobei die Summe aus x, y und z stets 1 ergibt.

6. Verfahren nach einem der Ansprüche 1 bis 4, wobei in der Stufe D) der III/V Halbleiter ein GaN_{w}Pᵥ Halbleiter ist, wobei w = 0-0,1 und v = 1-w.

7. Verfahren nach einem der Ansprüche 1 bis 6, wobei in der Stufe E) der III/V Halbleiter ein GaₓB_{y}Al_{z}P Halbleiter ist, wobei x = 0-1, y = 0-0,1 und z = 0-1, wobei die Summe aus x, y und z stets 1 ergibt.

8. Verfahren nach einem der Ansprüche 1 bis 6, wobei in der Stufe E) der III/V Halbleiter ein GaN_{w}Pᵥ Halbleiter ist, wobei w = 0-0,1 und v = 1-w.

9. Verfahren nach einem der Ansprüche 1 bis 8, wobei in der Stufe D) der III-V Halbleiter eine Dotierung mit Zn, Te, S, C, Mg und/oder Si in einer Dotierungskonzentration 10¹⁵-10²¹ cm⁻³ aufweist.

10. Verfahren nach einem der Ansprüche 1 bis 9, wobei in der Stufe E) der III-V Halbleiter eine Dotierung mit Zn, Te, S, C, Mg und/oder Si in einer Dotierungskonzentration 10¹⁵-10²¹ cm⁻³ aufweist.

11. Verfahren nach einem der Ansprüche 1 bis 10, wobei das Substrat einen Durchmesser von mehr als 6 cm aufweist.

12. Verfahren nach einem der Ansprüche 1 bis 10, wobei das Substrat einen Durchmesser von mehr als 10 cm aufweist.

13. Verfahren nach einem der Ansprüche 1 bis 10, wobei das Substrat einen Durchmesser von mehr als 20 cm aufweist.

## Claims

1. A process to produce a monolithic template containing a Si wafer with a layer of a III-V semiconductor epitaxially deposited on a surface of the Si wafer, wherein the III-V semiconductor has a lattice constant that deviates less than 10% from that of the Si, this process comprising the following steps:
B) Epitaxially growing a Si layer on the surface of the Si wafer at a wafer temperature of 600-1,200°C, a growth rate of 0.01-20 µm/h, and a layer thickness of up to 5 µm;
C) Subjecting a surface of the Si layer to an etching process step by means of an active Cl-containing gas, at a wafer temperature of 600-1,200°C for a duration of up to 60 minutes over the surface at an etching rate of up to 5 µm/h;
D) Epitaxially growing the layer of the III-V semiconductor on the surface of the Si wafer at a wafer temperature of 350-650°C, a growth rate of 0.1-2 µm/h, and a layer thickness of 1-100 nm;
E) Epitaxially growing, on the layer obtained in step D), a layer of a III-V semiconductor that is the same as or different from the III-V semiconductor deposited in step D), at a wafer temperature of 500-800°C, a growth rate of 0.1-10 µm/h, and a layer thickness of 10-150 nm.

2. The process described in claim 1, wherein step C) is preceded by a step A) comprising deoxidation of the Si wafer surface by baking at a wafer temperature of 800-1,200°C for a duration of 1 s to 30 minutes in an inert gas atmosphere.

3. The process described in one of claims 1 or 2, wherein in step D) the layer is epitaxially grown by means of atomic layer deposition (ALD).

4. The process described in claim 1, wherein the surface of the Si wafer is a (001) Si surface with 0-6° misorientation in direction <110>, wherein if the misorientation is < 1°, the direction of the misorientation can deviate from <110>.

5. The process described in one of claims 1 through 4, wherein the III-V semiconductor in step D) is a GaₓB_{y}Al_{z}P semiconductor, where x = 0-1, y = 0-0.1, and z = 0-1, and the total of x, y, and z is always 1.

6. The process described in one of the claims 1 through 4, wherein the III-V semiconductor in step D) is a GaN_{w}Pᵥ semiconductor, where w = 0-0.1 and v = 1-w.

7. The process described in one of claims 1 through 6, wherein the III-V semiconductor in step E) is a GaₓB_{y}Al_{z}P semiconductor, where x = 0-1, y = 0-0.1, and z = 0-1, and the total of x, y, and z is always 1.

8. The process described in one of the claims 1 through 6, wherein the III-V semiconductor in step E) is a GaN_{w}Pᵥ semiconductor, where w = 0-0.1 and v = 1-w.

9. The process described in one of the claims 1 through 8, wherein the III-V semiconductor in step D) is doped with Zn, Te, S, C, Mg, and/or Si in a dopant concentration of 10¹⁵-10²¹ cm⁻³.

10. The process described in one of the claims 1 through 9, wherein the III-V semiconductor in step E) is doped with Zn, Te, S, C, Mg, and/or Si in a dopant concentration of 10¹⁵-10²¹ cm⁻³.

11. The process described in one of the claims 1 through 10, wherein the substrate has a diameter of more than 6 cm.

12. The process described in one of the claims 1 through 10, wherein the substrate has a diameter of more than 10 cm.

13. The process described in one of the claims 1 through 10, wherein the substrate has a diameter of more than 20 cm.

## Revendications

1. Procédé de fabrication d'un gabarit monolithique contenant une tranche de Si avec une couche d'un semi-conducteur III/V rapportée par épitaxie sur une surface de la tranche de Si, dans lequel le semi-conducteur III/V présente une constante de grille qui est inférieure de 10 % de celle du Si, avec les étapes de procédé suivantes :
B) une couche de Si est mise à croître par épitaxie à une température de 600 à 1200 C, un taux de croissance de 0,01 à 20 µm/h et une épaisseur de couche jusqu'à 5 µm sur la surface de la tranche de Si,
C) une surface de la tranche de Si est soumise à une étape d'un procédé de gravure au moyen d'un gaz actif contenant du Cl, à une température de la tranche de 600 à 1200 °C pendant une durée jusqu'à 60 min sur la surface à un taux de gravure jusqu'à 5 µm/h,
D) sur la surface de la couche de Si, la couche constituée du semi-conducteur III/V est mise à croître par épitaxie à une température de la tranche de 350 à 650 °C, un taux de croissance de 0,1 à 2 µm/h et une épaisseur de couche de 1 à 100 nm,
E) sur la couche obtenue dans l'étape D), une couche constituée d'un semi-conducteur III/V identique ou différent de celui rapporté à l'étape D), est mise à croître par épitaxie à une température de tranche de 500 à 800 °C, un taux de croissance de 0,1 à 10 µm/h et une épaisseur de couche de 10 à 150 nm.

2. Procédé selon la revendication 1, dans lequel, avant l'étape C), la surface de la tranche de Si des désoxydée dans une étape A) par un chauffage à une température de tranche de 800 à 1200 °C pour une durée de 1 s à 30 min dans une atmosphère d'un gaz inerte.

3. Procédé selon l'une des revendications 1 ou 2, dans lequel, dans l'étape D), la couche est mise à croître par épitaxie au moyen d'un dépôt de couches atomiques (atomic layer deposition ALD).

4. Procédé selon la revendication 1, dans lequel la surface de la tranche de Si est une surface (001) Si avec une désorientation de 0 à 6° dans la direction <110>, où, pour une désorientation ≤ 1 °, la direction de la désorientation peut dévier de <110>.

5. Procédé selon l'une des revendications 1 à 4, où, dans l'étape D), le semi-conducteur III/V est un semi-conducteur GaₓB_{y}Al_{z}P, où x = 0 à 1, y = 0 à 0,1 et z = 0 à 1, où la somme constituée par x, y et z donne toujours 1.

6. Procédé selon l'une des revendications 1 à 4, où, dans l'étape D), le semi-conducteur III/V est un semi-conducteur GaN_{w}Pᵥ, où w - 0 à 0,1 et v = 1 - w.

7. Procédé selon l'une des revendications 1 à 6, où, dans l'étape E), le semi-conducteur III/V est un semi-conducteur GaₓB_{y}Al_{z}P, où x = 0 à 1, y = 0 à 0,1 et z = 0 à 1, où la somme constituée par x, y et z donne toujours 1.

8. Procédé selon l'une des revendications 1 à 6, où, dans l'étape E), le semi-conducteur III/V est un semi-conducteur GaN_{w}Pᵥ, où w = 0 à 0,1 et v = 1 - w.

9. Procédé selon l'une des revendications 1 à 8, où, dans l'étape D), le semi-conducteur III/V présente un dopage avec du Zn, du Te, du S, du C, du Mg et/ou du Si à une concentration de dopant de 10¹⁵ à 10²¹ cm⁻³.

10. Procédé selon l'une des revendications 1 à 9, où, dans l'étape E), le semi-conducteur III/V présente un dopage avec du Zn, du Te, du S, du C, du Mg et/ou du Si à une concentration de dopant de 10¹⁵ à 10²¹ cm⁻³.

11. Procédé selon l'une des revendications 1 à 10, dans lequel le substrat présente un diamètre supérieur à 6 cm.

12. Procédé selon l'une des revendications 1 à 10, dans lequel le substrat présente un diamètre supérieur à 10 cm.

13. Procédé selon l'une des revendications 1 à 10, dans lequel le substrat présente un diamètre supérieur à 20 cm.
